(19)

**Europäisches Patentamt**
**European Patent Office**
**Office européen des brevets**

(11) **EP 3 651 069 B1**

(12) **EUROPEAN PATENT SPECIFICATION**

(45) Date of publication and mention
of the grant of the patent:
**15.10.2025 Bulletin 2025/42**

(21) Application number: **17916616.0**

(22) Date of filing: **07.07.2017**

(51) International Patent Classification (IPC):
**G06N 3/02** (2006.01)  **H03M 7/30** (2006.01)
**G06N 3/063** (2023.01)

(52) Cooperative Patent Classification (CPC):
**G06N 3/063; G06N 3/045; H03M 7/30;** G06N 3/048

(86) International application number:
**PCT/JP2017/024992**

(87) International publication number:
**WO 2019/008752 (10.01.2019 Gazette 2019/02)**

(54) **DATA PROCESSING DEVICE, DATA PROCESSING METHOD, AND COMPRESSED DATA**

DATENVERARBEITUNGSVORRICHTUNG, DATENVERARBEITUNGSVERFAHREN UND
KOMPRIMIERTE DATEN

DISPOSITIF DE TRAITEMENT DE DONNÉES, PROCÉDÉ DE TRAITEMENT DE DONNÉES ET
DONNÉES COMPRESSÉES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**13.05.2020 Bulletin 2020/20**

(73) Proprietor: **Mitsubishi Electric Corporation
Chiyoda-ku
Tokyo 100-8310 (JP)**

(72) Inventors:
• **MINEZAWA, Akira
Tokyo 100-8310 (JP)**
• **MORIYA, Yoshimi
Tokyo 100-8310 (JP)**
• **WANG, Mengxiong
Tokyo 100-8310 (JP)**
• **SUGIMOTO, Kazuo
Tokyo 100-8310 (JP)**

(74) Representative: **Pfenning, Meinig & Partner mbB
Patent- und Rechtsanwälte
Joachimsthaler Straße 10-12
10719 Berlin (DE)**

(56) References cited:
• **SAJID ANWAR ET AL: "Fixed point optimization
of deep convolutional neural networks for object
recognition", 2015 IEEE INTERNATIONAL
CONFERENCE ON ACOUSTICS, SPEECH AND
SIGNAL PROCESSING (ICASSP), 1 April 2015
(2015-04-01), pages 1131 - 1135, XP055284772,
ISBN: 978-1-4673-6997-8, DOI: 10.1109/
ICASSP.2015.7178146**
• **DARRYL D LIN ET AL: "Fixed Point Quantization
of Deep Convolutional Networks", 19 November
2015 (2015-11-19), pages 1 - 10, XP055284812,
Retrieved from the Internet <URL:https://arxiv.
org/pdf/1511.06393v3.pdf> [retrieved on
20160630]**
• **SONG HAN ET AL: "Deep Compression:
Compressing Deep Neural Networks with
Pruning, Trained Quantization and Huffman
Coding", 15 February 2016 (2016-02-15),
XP055393078, Retrieved from the Internet
<URL:https://arxiv.org/pdf/1510.00149v5.pdf>
[retrieved on 20170721]**
• **VINCENT VANHOUCKE ET AL: "Improving the
speed of neural networks on CPUs", 17
December 2011 (2011-12-17), XP055175306,
Retrieved from the Internet <URL:https://
deeplearningworkshopnips2011.files.
wordpress.com/2011/12/8.pdf> [retrieved on
20150310]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**EP 3 651 069 B1**

**(Cont. next page)**

• HAN, SONG ET AL: "DEEP COMPRESSION: COMPRESSING DEEP NEURAL NETWORKS WITH PRUNING, TRAINED QUANTIZATION AND HUFFMAN CODING", ICLR 2016, 15 February 2016 (2016-02-15), XP055393078

## Description

TECHNICAL FIELD

The invention relates to a data processing device and a data processing method that encode and compress information about a configuration of a neural network, and relates to compressed data.

BACKGROUND ART

As a method for solving classification problems and regression problems of input data, there is machine learning.

For the machine learning, there is a technique called a neural network that imitates a brain's neural circuit (neurons). In the neural network, classification (discrimination) or regression of input data is performed using a probabilistic model (a discriminative model or a generative model) represented by a network in which neurons are mutually connected to each other.

Furthermore, in a convolutional neural network which is a neural network having not only a fully-connected layer but also a convolution layer and a pooling layer, a network can be created that implements data processing other than classification and regression, such as a network that implements a data filtering process. For example, a convolutional neural network can implement an image or audio filtering process that achieves noise removal of an input signal, an improvement in quality, or the like, with an image or audio being an input, a high-frequency restoration process for audio with missing high frequencies such as compressed audio, inpainting for an image whose region is partially missing, a super-resolution process for an image, etc.

In addition to the above, in recent years, there has also been released a new neural network called a generative adversarial network in which the network is constructed by combining a generative model and a discriminative model that are used to determine whether data is real by inputting the data to the discriminative model that determines whether data generated by the generative model is real data (whether the data is not data generated by the generative model), and the generative model is adversarially trained in such a manner that the discriminative model cannot distinguish generated data as generated data, and the discriminative model is adversarially trained so as to be able to distinguish generated data as generated data, by which creation of a generative model with high accuracy is implemented.

In these neural networks, by optimizing network parameters by training using a large amount of data, an improvement in performance can be achieved.

Note, however, that there is a tendency that the data size of a neural network becomes large, and computational load on a computer using the neural network also increases.

Regarding this, Non-Patent Literature 1 describes a technique for scalar-quantizing and encoding edge weights which are parameters of a neural network. By scalar-quantizing and encoding the edge weights, the data size of data about edges is compressed. Non-Patent Literature 2 concerns fixed point quantization of deep convolutional networks.

CITATION LIST

PATENT LITERATURES

Non-Patent Literature 1: Vincent Vanhoucke, Andrew Senior, Mark Z. Mao, "Improving the speed of neural networks on CPUs," Proc. Deep Learning and Unsupervised Feature Learning NIPS Workshop, 2011.
Non-Patent Literature 2: SAJID ANWAR ET AL, "Fixed point optimization of deep convolutional neural networks for object recognition", 2015 IEEE INT. CONF. ON ACOUSTICS, SPEECH AND SIGNAL PROCESSING (ICASSP).

SUMMARY OF INVENTION

TECHNICAL PROBLEM

However, the optimal values of weights assigned to a respective plurality of edges in a neural network vary depending on network training results and are not fixed.

Hence, variations occur in the compression size of edge weights, and the technique described in Non-Patent Literature 1 has a problem that high compression of parameter data about edges of a neural network cannot be achieved.

The invention is to solve the above-described problem, and an object of the invention is to obtain a data processing device and a data processing method that can highly compress parameter data of a neural network, and compressed data.

SOLUTION TO PROBLEM

A data processing device according to the invention includes a data processing unit, a compression controlling unit, and an encoding unit. The data processing unit processes input data using a neural network. The compression controlling unit determines quantization steps and generates quantization information that defines the quantization steps, the quantization steps being used when parameter data of the neural network is quantized. The encoding unit encodes network configuration information and the quantization information to generate compressed data, the network configuration information including the parameter data quantized using the quantization steps determined by the compression controlling unit. Furthermore, the compression controlling unit is configured to change the quantization steps on a node-by-node or kernel-by-kernel basis and the encoding unit is configured to encode the quantization information that defines the node-by-node or kernel-by-kernel quantization steps. When quantization steps are set for on a kernel-by-kernel basis a common quantization step is used among a plurality of kernel indices or a plurality of edge indices, or among a plurality of kernel indices and edge indices. When quantization steps are set on a node-by-node basis a common quantization step is used among a plurality of node indices or the plurality of edge indices, or among a plurality of node indices and edge indices.

ADVANTAGEOUS EFFECTS OF INVENTION

According to the invention, quantization information that defines quantization steps which are used when parameter data of a neural network is quantized, and network configuration information including the parameter data quantized using the quantization steps in the quantization information are encoded to generate compressed data. Accordingly, the parameter data of the neural network can be highly compressed.

By using quantization information and network configuration information which are decoded from the compressed data, a neural network optimized on the encoding side can be constructed on the decoding side.

BRIEF DESCRIPTION OF DRAWINGS

FIG. 1 is a block diagram showing a configuration of a data processing device (encoder) according to a first embodiment of the invention.
FIG. 2 is a block diagram showing a configuration of a data processing device (decoder) according to the first embodiment.
FIG. 3A is a block diagram showing a hardware configuration that implements the functions of a data processing device according to the first embodiment, and FIG. 3B is a block diagram showing a hardware configuration that executes software that implements the functions of the data processing device according to the first embodiment.
FIG. 4 is a flowchart showing the operation of the data processing device (encoder) according to the first embodiment.
FIG. 5 is a flowchart showing the operation of the data processing device (decoder) according to the first embodiment.
FIG. 6 is a diagram showing an exemplary configuration of a neural network in the first embodiment.
FIG. 7 is a diagram showing an example of a convolution process for one-dimensional data in the first embodiment.
FIG. 8 is a diagram showing an example of a convolution process for two-dimensional data in the first embodiment.
FIG. 9 is a diagram showing a matrix of node-by-node edge weight information in an lth layer of a neural network.
FIG. 10 is a diagram showing a matrix of quantization steps for the node-by-node edge weight information in the lth layer of the neural network.
FIG. 11 is a diagram showing a matrix of edge weight information in a convolutional layer.
FIG. 12 is a diagram showing a matrix of quantization steps for the edge weight information in the convolutional layer.
FIG. 13 is a diagram showing syntax of information included in quantization information in the first embodiment.
FIG. 14 is a diagram showing syntax for each matrix of information included in the quantization information in the first embodiment.
FIG. 15 is a diagram showing syntax for each layer of information included in the quantization information in the first embodiment.

DESCRIPTION OF EMBODIMENTS

To more specifically describe the invention, modes for carrying out the invention will be described below with reference to the accompanying drawings. First Embodiment.

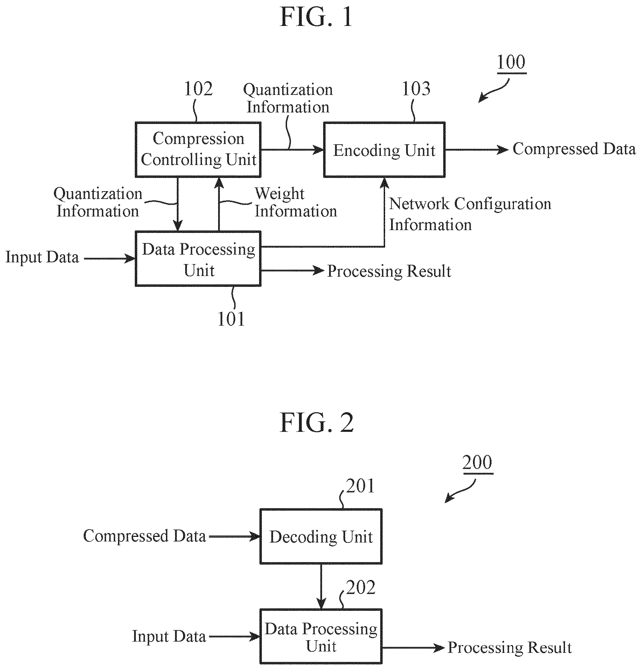

FIG. 1 is a block diagram showing a configuration of a data processing device 100 according to a first embodiment of the invention. In FIG. 1, the data processing device 100 processes input data using a trained neural network, and outputs processing results.

In addition, the data processing device 100 functions as an encoder that encodes quantization information and network configuration information, and includes a data processing unit 101, a compression controlling unit 102, and an encoding unit 103.

The data processing unit 101 processes input data using the above-described neural network.

In addition, the data processing unit 101 accepts, as input, quantization information generated by the compression controlling unit 102, and quantizes parameter data of the neural network using quantization steps defined in the quantization information. Then, the data processing unit 101 outputs network configuration information including the above-described quantized parameter data to the encoding unit 103.

For the above-described neural network used by the data processing unit 101, a predetermined neural network may be used, or the parameter data may be optimized by training.

When parameter data of a neural network is trained, neural network training is performed on the neural network in a predetermined initial state (initial values of the parameter data) using input data to be trained, and then quantization information generated by the compression controlling unit 102 is inputted, and the parameter data of the neural network is quantized using quantization steps defined in the quantization information.

Then, with the quantized neural network being in an initial state for the next training, the above-described training and quantization are performed. A neural network obtained as a result of repeating the training and quantization processes L times (L is an integer greater than or equal to one) is outputted, as a part of network configuration information, to the encoding unit 103.

Note that when L = 1, the quantized neural network is not retrained and thus it can be said that this is the same process as using a neural network that is trained outside without being trained by the data processing unit 101. That is, the difference is only whether training is performed by the data processing unit 101 or outside.

The network configuration information is information indicating a configuration of the neural network, and includes, for example, the number of network layers, the number of nodes for each of the layers, edges that link nodes, weight information assigned to each of the edges, activation functions representing outputs from the nodes, and type information for each of the layers (e.g., a convolutional layer, a pooling layer, or a fully-connected layer).

The parameter data of the neural network includes, for example, weight information assigned to edges that connect nodes of the neural network.

The compression controlling unit 102 determines quantization steps which are used when the parameter data of the neural network is quantized, and generates quantization information that defines the quantization steps.

For example, the compression controlling unit 102 determines quantization steps that change on an edge-by-edge, or kernel-by-kernel basis in the neural network.

The quantization information is information that defines quantization steps which are used when the parameter data of the neural network is quantized. The quantization step is a width (quantization width) used when parameter data is quantized, and the larger the quantization step is, the more coarsely the parameter data is broken down, and thus, the compression ratio increases. The smaller the quantization step is, the more finely the parameter data is broken down, and thus, the compression ratio decreases.

Specifically, a quantized value k is represented by the following equation (1):

$$k = \text{floor}((x/Q) + d_0) + d_1 \qquad (1)$$

In the above-described equation (1), x represents the value of a parameter to be quantized, Q re-

presents a quantization step, $d_0$ ($0 \leq d_0 < 1$) represents an adjustment offset in a range of values to be quantized that correspond to respective quantized values, $d_1$ ($0 \leq d_1 < 1$) represents an offset that adjusts the quantized value, and floor() represents a round-down processing function. Furthermore, there is also a method for providing a dead zone in which quantized values k for values x to be quantized within a range set in the above-described equation (1) are 0.

In addition, the value y of a quantized parameter is as shown in the following equation (2):

$$y = kQ \qquad (2)$$

When the minimum change unit of the quantization steps described above is changed from units of edges to units of layers, the compression ratio of parameter data by quantization increases, and thus, pre-encoding parameter data can be reduced.

The encoding unit 103 encodes the network configuration information including the parameter data quantized by the data processing unit 101 and the quantization information generated by the compression controlling unit 102, to generate compressed data.

Note that the network configuration information inputted to the encoding unit 103 from the data processing unit 101 is network configuration information including the parameter data which is quantized by the data processing unit 101 using the quantization steps determined by the compression controlling unit 102.

FIG. 2 is a block diagram showing a configuration of a data processing device 200 according to the first embodiment. In FIG. 2, the data processing device 200 processes input data using a neural network obtained by decoding compressed data, and outputs processing results. The processing results include classification results or regression analysis results of the input data, as with the data processing device 100.

The data processing device 200 functions as a decoder that decodes quantization information and network configuration information from compressed data, and includes a decoding unit 201 and a data processing unit 202.

The decoding unit 201 decodes quantization information and network configuration information from the compressed data encoded by the encoding unit 103 as described above.

The network configuration information decoded by the decoding unit 201 includes results (quantized values k) obtained by quantizing parameter data such as edge weight information, the edge weight information having been optimized as a result of performing training on a side of the data processing device 100 which is an encoder.

The quantization information decoded by the decoding unit 201 defines quantization steps Q which are used when the parameter data is quantized. From the above-described results k obtained by quantizing the parameter data and the above-described quantization steps Q, quantized parameters y are decoded in accordance with the above-described equation (2). These decoding results are outputted from the decoding unit 201 to the data processing unit 202.

The data processing unit 202 processes input data using a neural network.

**In** addition, the data processing unit 202 inversely quantizes the edge weight information which is parameter data, using the quantization information and network configuration information decoded from the compressed data by the decoding unit 201. Furthermore, the data processing unit 202 constructs a neural network using the network configuration information including the inversely quantized parameter data.

As such, the data processing unit 202 constructs a neural network including parameter data such as edge weight information which has been optimized as a result of performing training on the data processing device 100 side, using information decoded from compressed data, and processes input data using the neural network. Accordingly, the compression size of the optimized parameter data can be made uniform between the data processing device 100 and the data processing device 200, thereby being able to achieve high compression of the parameter data.

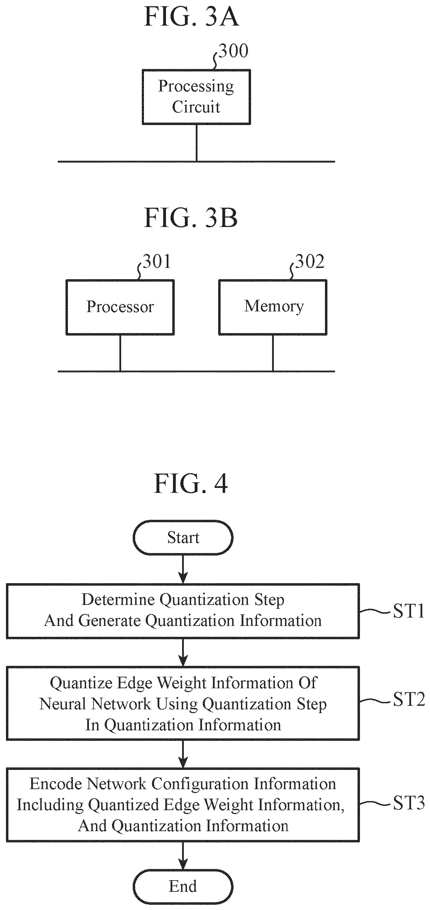

FIG. 3A is a block diagram showing a hardware configuration that implements the functions of the data processing device 100. In FIG. 3A, a processing circuit 300 is a dedicated circuit that functions as the data processing device 100. FIG. 3B is a block diagram showing a hardware configuration that executes software that implements the functions of the data processing device 100. In FIG. 3B, a processor 301 and a memory 302 are connected to each other by a signal bus.

The functions of the data processing unit 101, the compression controlling unit 102, and the encoding unit 103 in the data processing device 100 are implemented by a processing circuit.

Namely, the data processing device 100 includes a processing circuit for performing processes at step ST1 to ST3 which will be described later with reference to FIG. 4.

The processing circuit may be dedicated hardware, but may be a Central Processing Unit (CPU) that executes programs stored in a memory.

When the above-described processing circuit is the dedicated hardware shown in FIG. 3A, the processing circuit 300 corresponds, for example, to a single circuit, a composite circuit, a programmed processor, a parallel programmed processor, an Application Specific Integrated Circuit (ASIC), a Field-Programmable Gate Array (FPGA), or a combination thereof.

Note that the functions of the data processing unit 101, the compression controlling unit 102, and the encoding unit 103 may be implemented by different respective processing circuits, or the functions may be collectively implemented by a single processing circuit.

When the above-described processing circuit is the processor shown in FIG. 3B, the functions of the data processing unit 101, the compression controlling unit 102, and the encoding unit 103 are implemented by software, firmware, or a combination of software and firmware.

The software or firmware is described as programs and stored in the memory 302.

The processor 301 implements the functions of the data processing unit 101, the compression controlling unit 102, and the encoding unit 103, by reading and executing the programs stored in the memory 302. Namely, the data processing device 100 includes the memory 302 for storing programs that when executed by the processor 301, cause the processes at step ST1 to ST3 shown in FIG. 4 to be consequently performed.

The programs cause a computer to perform procedures or methods of the data processing unit 101, the compression controlling unit 102, and the encoding unit 103.

The memory 302 may be a computer readable storage medium having stored therein programs for causing a computer to function as the data processing unit 101, the compression controlling unit 102, and the encoding unit 103.

The memory 302 corresponds, for example, to a nonvolatile or volatile semiconductor memory such as a Random Access Memory (RAM), a Read Only Memory (ROM), a flash memory, an Erasable Programmable Read Only Memory (EPROM), or an Electrically-EPROM (EEPROM), a magnetic disk, a flexible disk, an optical disc, a compact disc, a MiniDisc, or a DVD.

Note that some of the functions of the data processing unit 101, the compression controlling unit 102, and the encoding unit 103 may be implemented by dedicated hardware, and some of the functions may be implemented by software or firmware.

For example, the function of the data processing unit 101 may be implemented by a processing circuit which is dedicated hardware, and the functions of the compression controlling unit 102 and the encoding unit 103 may be implemented by the processor 301 reading and executing programs stored in the memory 302.

As such, the processing circuit can implement the above-described functions by hardware, software, firmware, or a combination thereof.

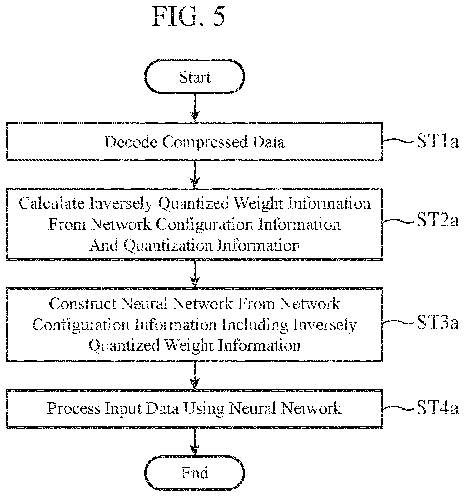

Note that although the data processing device 100 is described, the same also applies to the data processing device 200. For example, the data processing device 200 includes a processing circuit for performing processes at step ST1a to ST4a which will be described later with reference to FIG. 5. The processing circuit may be dedicated hardware, but may be a CPU that executes programs stored in a memory.

When the above-described processing circuit is the dedicated hardware shown in FIG. 3A, the processing circuit 300 corresponds, for example, to a single circuit, a composite circuit, a programmed processor, a parallel programmed processor, an ASIC, an FPGA, or a combination thereof.

Note that the functions of the decoding unit 201 and the data processing unit 202 may be implemented by different respective processing circuits, or the functions may be collectively implemented by a single processing circuit.

When the above-described processing circuit is the processor shown in FIG. 3B, the functions of the decoding unit 201 and the data processing unit 202 are implemented by software, firmware, or a combination of software and firmware.

The software or firmware is described as programs and stored in the memory 302.

The processor 301 implements the functions of the decoding unit 201 and the data processing unit 202, by reading and executing the programs stored in the memory 302.

Namely, the data processing device 200 includes the memory 302 for storing programs that when executed by the processor 301, cause the processes at step ST1a to ST4a shown in FIG. 5 to be consequently performed.

The programs cause a computer to perform procedures or methods of the decoding unit 201 and the data processing unit 202.

The memory 302 may be a computer readable storage medium having stored therein programs for causing a computer to function as the decoding unit 201 and the data processing unit 202.

Note that some of the functions of the decoding unit 201 and the data processing unit 202 may be implemented by dedicated hardware, and some of the functions may be implemented by software or firmware.

For example, the function of the decoding unit 201 may be implemented by a processing circuit which is dedicated hardware, and the function of the data processing unit 202 may be implemented by the processor 301 reading and executing a program stored in the memory 302.

Next operation will be described.

FIG. 4 is a flowchart showing the operation of the data processing device 100.

The following describes a case in which parameter data of a neural network is edge weight information.

The compression controlling unit 102 determines a quantization step which is used when weight information of each of a plurality of edges included in a trained neural network is quantized, and generates quantization information that defines the quantization step (step ST1). The quantization information is outputted from the compression controlling unit 102 to the data processing unit 101 and the encoding unit 103.

When the data processing unit 101 accepts, as input, the quantization information from the compression controlling unit 102, the data processing unit 101 quantizes the above-described edge weight information of the neural network using the quantization step in the quantization information (step ST2). The data processing unit 101 generates network configuration information including the quantized edge weight information, and outputs the network configuration information to the encoding unit 103.

The encoding unit 103 encodes the above-described network configuration information inputted from the data processing unit 101 and the above-described quantization information inputted from the compression controlling unit 102 (step ST3).

Compressed data of the above-described network configuration information and quantization information encoded by the encoding unit 103 is outputted to the data processing device 200.

FIG. 5 is a flowchart showing the operation of the data processing device 200.

The decoding unit 201 decodes quantization information and network configuration information from the above-described compressed data encoded by the encoding unit 103 (step ST1a). The quantization information and the network configuration information are outputted from the decoding unit 201 to the data processing unit 202.

Then, the data processing unit 202 calculates edge weight information which is inversely quantized using the quantization information and network configuration information decoded from the compressed data by the decoding unit 201 (step ST2a).

Subsequently, the data processing unit 202 constructs a neural network using the network configuration information including the inversely quantized edge weight information (step ST3a).

Accordingly, the data processing device 200 can construct the neural network trained by the data processing device 100.

The data processing unit 202 processes input data using the neural network constructed at step ST3a (step ST4a).

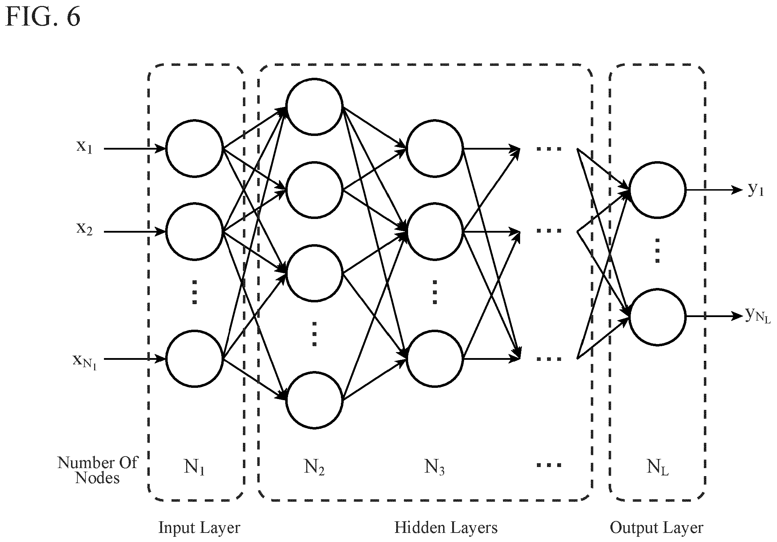

FIG. 6 is a diagram showing an exemplary configuration of a neural network in the first embodiment.

In the neural network shown in FIG. 6, input data $(x_1, x_2, ..., x_{N1})$ is processed by each layer, and processing results $(y_1, ..., y_{NL})$ are outputted.

In FIG. 6, $N_l$ (l = 1, 2, ..., L) represents the number of nodes in an lth layer, and L represents the number of layers in the neural network.

As shown in FIG. 6, the neural network includes an input layer, hidden layers, and an output layer, and is structured in such a manner that in each of these layers a plurality of nodes are linked by edges.

An output value of each of the plurality of nodes can be calculated, from an output value of a node in the immediately previous layer which is linked to the corresponding one of the plurality of nodes by an edge, weight information of the edge, and an activation function set on a layer-by-layer basis.

An example of a neural network includes a Convolutional Neural Network (CNN). In hidden layers of the CNN, convolutional layers and pooling layers are alternately linked to each other, and one or more fully-connected neural network layers (fully-connected layers) are provided in accordance with final outputs. For activation functions for the convolutional layers, for example, ReLU functions are used.

Note that a network called a deep neural network (DNN) (which is also called deep learning, a deep CNN (DCNN), etc.) is a network including multiple CNN layers.

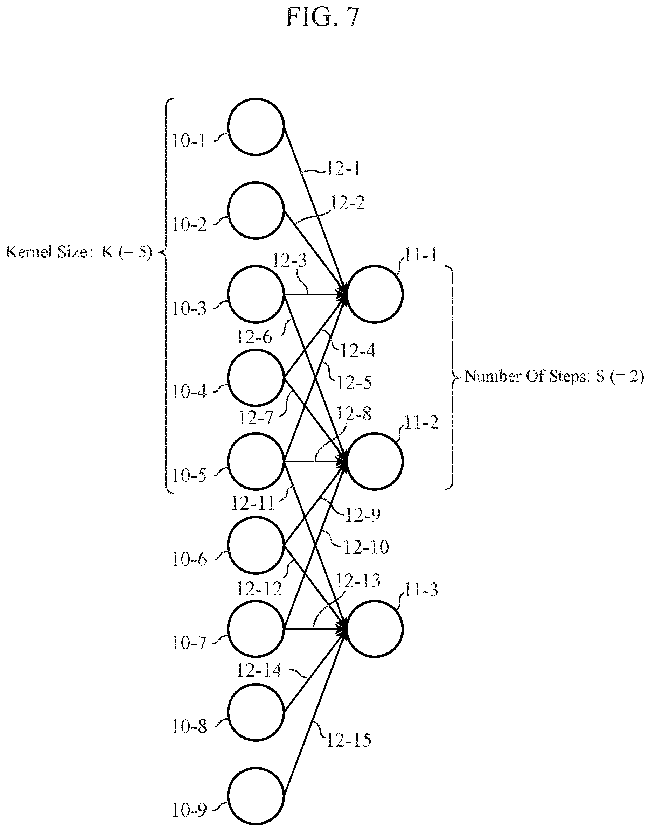

FIG. 7 is a diagram showing an example of a convolution process for one-dimensional data in the first embodiment, and shows a convolutional layer that performs a convolution process for one-dimensional data. The one-dimensional data includes, for example, audio data and time-series data.

The convolutional layer shown in FIG. 7 include nine nodes 10-1 to 10-9 in a previous layer and three nodes 11-1 to 11-3 in a subsequent layer.

Edges 12-1, 12-6, and 12-11 are each assigned an identical weight, edges 12-2, 12-7, and 12-12 are each assigned an identical weight, edges 12-3, 12-8, and 12-13 are each assigned an identical weight, edges 12-4, 12-9, and 12-14 are each assigned an identical weight, and edges 12-5, 12-10, and 12-15 are each assigned an identical weight. In addition, the weights of the edges 12-1 to 12-5 may all have different values, or some or all of the weights may have the same value.

Of the nine nodes 10-1 to 10-9 in the previous layer, five nodes are linked to one node in the subsequent layer with the above-described weights. The kernel size K is five, and the kernel is defined by a combination of these weights.

For example, as shown in FIG. 7, the node 10-1 is linked to a node 11-1 through the edge 12-1, the node 10-2 is linked to the node 11-1 through the edge 12-2, the node 10-3 is linked to the node 11-1 through the edge 12-3, the node 10-4 is linked to the node 11-1 through the edge 12-4, and the node 10-5 is linked to the node 11-1 through the edge 12-5. The kernel is defined by a combination of the weights of the edges 12-1 to 12-5.

The node 10-3 is linked to a node 11-2 through the edge 12-6, the node 10-4 is linked to the node 11-2 through the edge 12-7, the node 10-5 is linked to the node 11-2 through the edge 12-8, the node 10-6 is linked to the node 11-2 through the edge 12-9, and the node 10-7 is linked to the node 11-2 through the edge 12-10. The kernel is defined by a combination of the weights of the edges 12-6 to 12-10.

The node 10-5 is linked to a node 11-3 through the edge 12-11, the node 10-6 is linked to the node 11-3 through the edge 12-12, the node 10-7 is linked to the node 11-3 through the edge 12-13, the node 10-8 is linked to the node 11-3 through the edge 12-14, and the node 10-9 is linked to the node 11-3 through the edge 12-15. The kernel is defined by a combination of the weights of the edges 12-11 to 12-15.

In a process for input data using a CNN, the data processing unit 101 or the data processing unit 202 performs, for each kernel, a convolution operation at an interval of the number of steps S (in FIG. 7, S = 2) using a corresponding combination of edge weights of a convolutional layer. The combination of edge weights is determined for each kernel by training.

Note that in a CNN used for image recognition, the network is often constructed using a convolutional layer including a plurality of kernels.

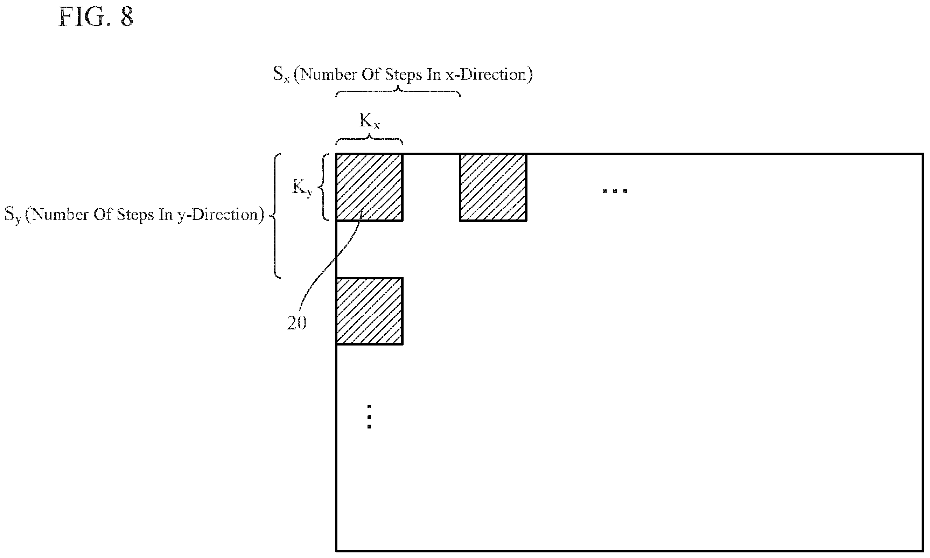

FIG. 8 is a diagram showing an example of a convolution process for two-dimensional data in the first embodiment, and shows a convolution process for two-dimensional data such as image data.

In the two-dimensional data shown in FIG. 8, a kernel 20 is a block region with a size of Kx in an x-direction and a size of Ky in a y-direction. The kernel size K is represented by K = Kx × Ky.

In the two-dimensional data, the data processing unit 101 or the data processing unit 202 performs a convolution operation on data for each kernel 20 at an interval of the number of steps Sx in the x-direction and an interval of the number of steps Sy in the y-direction. Here, the steps Sx and Sy are integers greater than or equal to one.

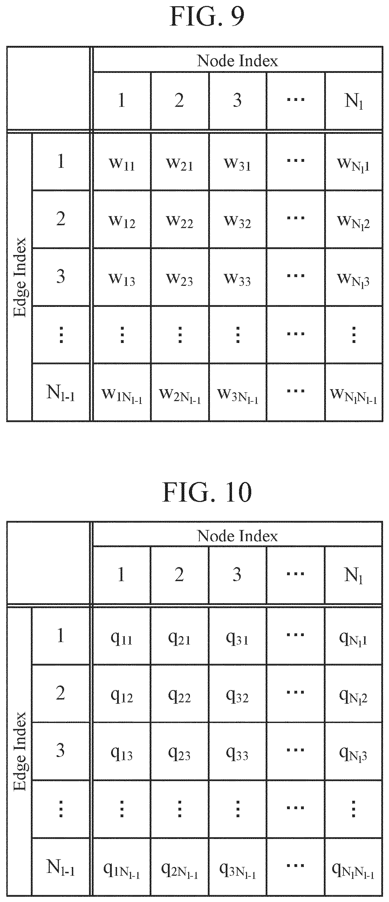

FIG. 9 is a diagram showing a matrix of node-by-node edge weight information in an lth layer (l = 1, 2, ..., L) which is a fully-connected layer of a neural network.

FIG. 10 is a diagram showing a matrix of quantization steps for the node-by-node edge weight information in the lth layer (l = 1, 2, ..., L) which is a fully-connected layer of the neural network.

In the neural network, a combination of weights $w_{ij}$ for each layer shown in FIG. 9 is data for constructing the network. Hence, in a multi-layer neural network such as a DNN, the amount of data is generally several hundred Mbytes or more and a large memory size is also required. Note that i is the node index and i = 1, 2, ..., Nl, and j is the edge index and j = 1, 2, ..., Nl-1.

Hence, in order to reduce the amount of data of edge weight information, the data processing device 100 according to the first embodiment quantizes the weight information. As shown in FIG. 10, the quantization steps $q_{ij}$ are set for the respective edge weights $w_{ij}$.

Furthermore, a common quantization step is used among a plurality of node indices or a plurality of edge indices, or among a plurality of node indices and edge indices. By doing so, quantization information to be encoded can be reduced.

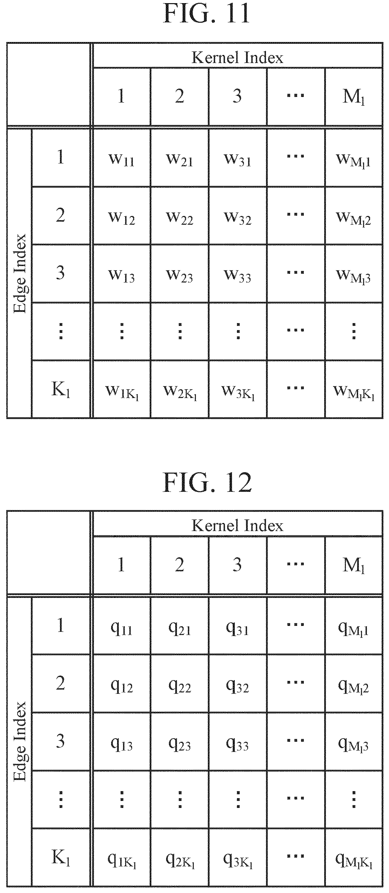

FIG. 11 is a diagram showing a matrix of edge weight information in a convolutional layer.

FIG. 12 is a diagram showing a matrix of quantization steps for the edge weight information in the convolutional layer. In the convolutional layer, an edge weight for a single kernel is common to all nodes, and by reducing the number of edges connected per node, i.e., the kernel size K, a kernel region can be made small.

FIG. 11 shows data of edge weights $w_{i'j'}$ set on a kernel-by-kernel basis, and FIG. 12 shows data of quantization steps $q_{i'j'}$ set on a kernel-by-kernel basis.

Note that i' is the kernel index and i' = 1, 2, ..., Ml (l = 1, 2, ..., L), and j' is the edge index and j' = 1, 2, ..., Kl.

Furthermore, a common quantization step is used among a plurality of kernel indices or a plurality of edge indices, or among a plurality of kernel indices and edge indices. By doing so, quantization information to be encoded can be reduced.

At step ST1 of FIG. 4, the compression controlling unit 102 determines quantization steps which are used in a weight quantization process performed by the data processing unit 101, and outputs the quantization steps as quantization information to the data processing unit 101. The quantization steps are the quantization steps $q_{ij}$ shown in FIG. 10 and the quantization steps $q_{i'j'}$ shown in FIG. 12.

At step ST2 of FIG. 4, the data processing unit 101 quantizes the edge weights $w_{ij}$ shown in FIG. 9 using the quantization steps $q_{ij}$ shown in FIG. 10, and outputs network configuration information including the quantized weights $w_{ij}$ to the encoding unit 103.

Likewise, at step ST2 of FIG. 4, the data processing unit 101 quantizes the edge weights $w_{i'j'}$ shown in FIG. 11 using the quantization steps $q_{i'j'}$ shown in FIG. 12, and outputs network configuration information including the quantized weights $w_{i'j'}$ to the encoding unit 103.

Note that the network configuration information includes, in addition to the quantized weights, the number of network layers, the number of nodes for each of the layers, edges that link nodes, weight information assigned to each of the edges, activation functions representing outputs from the nodes, type information for each of the layers (e.g., a convolutional layer, a pooling layer, or a fully-connected layer), etc. Note, however, that information that is fixed (defined) in advance between the data processing device 100 and the data processing device 200 is not included in network configuration information to be encoded.

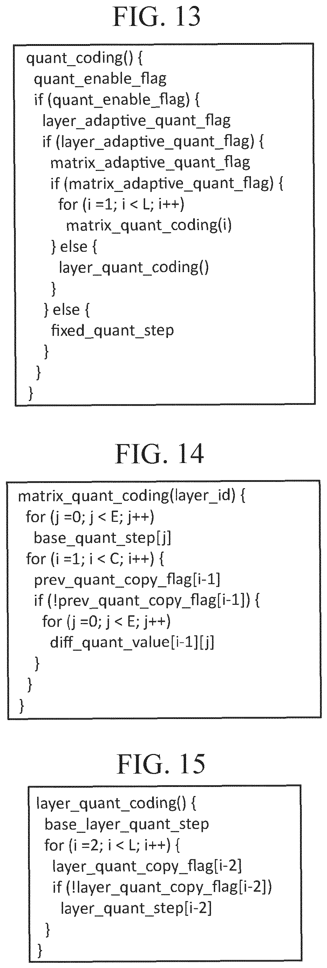

FIG. 13 is a diagram showing syntax of information included in quantization information in the first embodiment.

FIG. 14 is a diagram showing syntax for each matrix of information included in the quantization information in the first embodiment.

FIG. 15 is a diagram showing syntax for each layer of information included in the quantization information in the first embodiment.

In FIG. 13, the flag "quant_enable_flag", the flag "layer_adaptive_quant_flag", the flag "matrix_adaptive_quant_flag", and the quantization step "fixed_quant_step" are encoding parameters of quantization information to be encoded by the encoding unit 103.

In addition, L is the number of layers.

In FIG. 14, the quantization step "base_quant_step[j]", the flag "prev_quant_copy_flag [i-1]", and the difference value "diff_quant_value[i-1][j]" are encoding parameters of quantization information to be encoded by the encoding unit 103.

In addition, C is the number of nodes $N_{layer\_id}$ or the number of kernels $M_{layer\_id}$. Furthermore, E is the number of edges $N_{layer\_id-1}$ or the kernel size $K_{layer\_id}$.

In FIG. 15, the quantization step "base_layer_quant_step", the flag "layer_quant_copy_flag[i-2]", and the quantization step "layer_quant_step[i-2]" are encoding parameters of quantization information to be encoded by the encoding unit 103. In addition, L is the number of layers.

The information shown in FIG. 13 includes the flag "quant_enable_flag" that sets whether to quantize edge weight information in the network.

When the flag "quant_enable_flag" is 0 (false), all edge weight information in the network is not quantized. Namely, no quantization steps are set in the quantization information.

On the other hand, when the flag "quant_enable_flag" is 1 (true), the compression controlling unit 102 refers to the flag "layer_adaptive_quant_ flag".

When the flag "layer_adaptive_quant_ flag" is 0 (false), the compression controlling unit 102 sets, in the quantization information, the quantization step "fixed_quant_step" which is common to all edges in the network.

When the flag "layer_adaptive_quant_ flag" is 1 (true), the compression controlling unit 102 refers to the flag "matrix_adaptive_quant_flag".

When the flag "matrix_adaptive_quant_ flag" is 0 (false), the compression controlling unit 102 determines a quantization step which is common on a per-layer basis, as a quantization step for weight information of each of a plurality of edges in the network.

Note, however, that an input layer (first layer) has no edges and thus no quantization steps are set for the input layer.

Note that FIG. 15 shows syntax about a quantization step which is common on a per-layer basis.

When the flag "matrix_adaptive_quant_ flag" is 1 (true), the compression controlling unit 102 determines the quantization steps shown in FIG. 10 or the quantization steps shown in FIG. 12, as quantization steps for weight information of a plurality of respective edges in the network. FIG. 14 shows the syntax of the quantization steps shown in FIG. 10 or 12.

The syntax shown in FIG. 14 will be described.

As described above, the input layer (first layer) has no edges.

Hence, quantization steps are set for a layer_id+1th layer in which the ID information "layer_id" is 1 to L-1.

First, in the layer_id+1th layer, the compression controlling unit 102 sets base_quant_step[j] (j = 0, 1, ..., E-1) indicating a quantization step for the first node shown in FIG. 10 (the first kernel in FIG. 12).

Note that E is the number of edges $N_{layer\_id}$ or the kernel size $K_{layer\_id+1}$.

Then, for the second and subsequent nodes (or kernels) (i ≥ 1), the compression controlling unit 102 refers, on a node-by-node (or kernel-by-kernel) basis, to the flag "prev_quant_copy_flag[i-1]" indicating whether the quantization step is the same as that for a node (or a kernel) with an immediately previous index.

When the flag "prev_quant_copy_flag[i-1]" is 1 (true), an i+1th node (or kernel) has the same quantization step as that for an ith node (or kernel).

On the other hand, when the flag "prev_quant_copy_flag[i-1]" is 0 (false), the compression controlling unit 102 sets the difference value "diff_quant_value[i-1][j]" (i = 1, 2, ..., C-1, and j = 0, 1, ..., E-1) as information for generating a quantization step for the i+1th node (or kernel).

The quantization step can be generated by adding a quantization step set for an immediately previous node (kernel) to the difference value "diff_quant_value[i-1] [j]".

Namely, in the second node (or kernel) (i = 1), base_quant_step[j] + diff_quant_value[0][j] is a quantization step. In the third and subsequent nodes (or kernels) (i ≥ 2), diff_quant_value[i-2][j] + diff_quant_value[i-1][j] is a quantization step.

Note that although the difference value "diff_quant_value[i-1][j]" between the quantization steps of nodes (or kernels) is shown as an encoding parameter, an independent quantization step may be set on a per-node (or kernel) basis.

Configuring in this manner improves the encoding efficiency in the encoding unit 103 when there is a tendency that the correlation between the quantization steps of nodes (or kernels) is low.

The syntax shown in FIG. 15 will be described.

As described above, the input layer (first layer) has no edges.

Hence, the compression controlling unit 102 sets base_layer_quant_step as a quantization step which is common to all edge weight information in the second layer.

Then, for the third and subsequent layers (i ≥ 2), the compression controlling unit 102 refers to the flag "layer_quant_copy_flag[i-2]" (i = 2, 3, ..., L-1) indicating whether a quantization step which is common to all edge weight information in an i+1th layer is the same as a quantization step which is common to all edge weight information in an ith layer.

When the flag "layer_quant_copy_flag[i-2]" is 1 (true), the compression controlling unit 102 sets the same quantization step as the quantization step which is common to all edge weight information in the ith layer, as a quantization step which is common to all edge weight information in the i+1th layer. On the other hand, when the flag "layer_quant_copy_flag[i-2]" is 0 (false), the compression controlling unit 102 sets layer_quant_step[i-2] as a quantization step which is common to all edge weight information in the i+1th layer.

Note that although a case is shown in which the compression controlling unit 102 defines layer_quant_step[i-2] as a quantization step which is independent on a per-layer basis, layer_quant_step[i-2] may be defined as a difference value to a quantization step for an immediately previous layer (ith layer). By defining layer_quant_step[i-2] as a difference value, many difference values close to 0 occur, thereby being able to improve the encoding efficiency in the encoding unit 103.

The encoding unit 103 encodes the encoding parameters in FIGS. 13 to 15 as quantization information to generate compressed data.

Note that although the minimum change unit of quantization steps is units of edges, as shown in FIG. 10, the minimum change unit of quantization steps may be units of nodes (in FIG. 12, units of kernels). This has the same meaning as setting E = 1 in FIG. 14. In this case, the quantization steps may be independently encoded on a per-node basis (on a per-kernel basis in FIG. 12).

In addition, the minimum change unit of quantization steps may be units of layers.

This has the same meaning as always executing only layer quant_coding() without the flag "matrix_adaptive_quant_flag" when the flag "layer_adaptive_quant_ flag" = 1 (true) in FIG. 13. By thus making the minimum change unit of quantization steps larger than units of edges, the data size of pre-encoding quantization information can be reduced.

As described above, in the data processing device 100 according to the first embodiment, the data processing unit 101 processes input data using a neural network. The compression controlling unit 102 determines quantization steps, and generates quantization information that defines the quantization steps. The encoding unit 103 encodes network configuration information including parameter data which is quantized using the quantization steps determined by the compression controlling unit 102, and the quantization information, to generate compressed data.

Particularly, in the above-description, an example is described in which weight information assigned to edges that connect nodes in a neural network is handled as parameter data of the neural network. By having these configurations, quantization information that defines quantization steps, and network configuration information including parameter data which is quantized using the quantization steps in the quantization information are encoded into compressed data. Accordingly, the parameter data of the neural network can be highly compressed.

In addition, by using quantization information and network configuration information which are decoded from the compressed data, a neural network optimized on the encoding side can be constructed on the decoding side.

In the data processing device 200 according to the first embodiment, the data processing unit 202 processes input data using a neural network. The decoding unit 201 decodes compressed data.

In this configuration, the data processing unit 202 inversely quantizes parameter data using quantization information and network configuration information which are decoded from compressed data by the decoding unit 201, and constructs a neural network using the network configuration information including the inversely quantized parameter data.

Accordingly, a neural network optimized on the encoding side can be constructed using the quantization information and network configuration information decoded from the compressed data.

In a data processing device of a comparative example, the compression controlling unit changes quantization steps on an edge-by-edge basis. The encoding unit encodes quantization information that defines the edge-by-edge quantization steps.

In the data processing device 100 according to the first embodiment, the compression controlling unit 102 changes quantization steps on a node-by-node or kernel-by-kernel basis. The encoding unit 103 encodes quantization information that defines the node-by-node or kernel-by-kernel quantization steps.

By such a configuration, too, parameter data can be quantized with high accuracy.

Second Embodiment.

The first embodiment describes an example in which output results of a neural network are directly used as data processing results, but there is an exemplary application in which outputs of an intermediate layer of a neural network are used as features for data processing on image data and audio data, e.g., image retrieval or matching in the following reference, and the features are subjected to another data processing technique as shown in the following reference, by which final data processing results are obtained.

For example, when outputs of an intermediate layer of a neural network are used as image features for image processing such as image retrieval, matching, or object tracking, by substituting the outputs for or adding the outputs to image features such as a Histogram of Oriented Gradients (HOG), Scale Invariant Feature Transform (SIFT), and Speeded Up Robust Features (SURF) which are image features used in the above-described conventional image processing, image processing can be implemented using the same processing flow as that of image processing that uses the above-described conventional image features.

In this case, what is to be encoded as network configuration information and quantization information by the data processing device 100 is a portion of the neural network up to the intermediate layer in which outputs serving as features for data processing are obtained.

Furthermore, the data processing device 100 performs data processing such as image retrieval, using the above-described features for data processing. The data processing device 200 decodes the portion of the neural network up to the intermediate layer from compressed data, and performs data processing such as image retrieval, using outputs obtained by inputting input data, as features for the data processing.

(Reference) ISO/IEC JTC1/SC29/WG11/m39219, "Improved retrieval and matching with CNN feature for CDVA", Chengdu, China, Oct. 2016.

Therefore, in the data processing device 100 according to the second embodiment, the compression ratio of parameter data by quantization increases, thereby being able to reduce the amount of data of pre-encoding weight information. In the data processing device 200 according to the second embodiment, by creating a neural network by decoding compressed data which is outputted from the data processing device 100, data processing can be performed.

Note that the present invention is not limited to the above-described embodiments, and modifications to any component of the embodiments or omissions of any component of the embodiments are possible within the scope of the present claims.

INDUSTRIAL APPLICABILITY

Data processing devices according to the invention can highly compress parameter data of a neural network and thus can be used in, for example, image recognition techniques.

REFERENCE SIGNS LIST

10-1 to 10-9, 11-1 to 11-3: node, 12-1 to 12-15: edge, 20: kernel, 100, 200: data processing device, 101, 202: data processing unit, 102: compression controlling unit, 103: encoding unit, 201: decoding unit, 300: processing circuit, 301: processor, 302: memory.

**Claims**

1. A data processing device (100) comprising:

    a data processing unit (101) configured to process input data using a neural network;
    a compression controlling unit (102) configured to determine quantization steps and generating quantization information that defines the quantization steps, the quantization steps being used when parameter data of the neural network is quantized; and
    an encoding unit (103) configured to encode network configuration information and the quantization information to generate compressed data, the network configuration information including the parameter data quantized using the quantization steps determined by the compression controlling unit (102);

**characterized in that**

the compression controlling unit (102) is configured to change the quantization steps on an edge-by-edge, or kernel-by-kernel basis of the neural network, and
the encoding unit (201) is configured to encode the quantization information that defines the edge-by-edge, or kernel-by-kernel quantization steps,
wherein either
quantization steps are set on a kernel-by-kernel basis and a common quantization step is used among a plurality of kernel indices or a plurality of edge indices, or among a plurality of kernel indices and edge indices;
or
quantization steps are set on an edge-by-edge basis and a common quantization step is used among a plurality of node indices or the plurality of edge indices, or among a plurality of node indices and edge indices.

2. A data processing device (200) comprising:

a data processing unit (202) configured to process input data using a neural network; and
a decoding unit (201) configured to decode compressed data obtained by encoding quantization information and network configuration information, the quantization information defining quantization steps used when parameter data of the neural network is quantized, and the network configuration information including the parameter data quantized using the quantization steps in the quantization information, wherein
the data processing unit (202) is configured to inversely quantize the parameter data using the quantization information and the network configuration information which are decoded from the compressed data by the decoding unit (201), and construct the neural network using the network configuration information including the inversely quantized parameter data;

**characterized in that**

in the compressed data,
the quantization steps are changed on an edge-by-edge, or kernel-by-kernel basis of the neural network, and
the quantization information that defines the edge-by-edge, or kernel-by-kernel quantization steps is encoded,

wherein either
quantization steps are set on a kernel-by-kernel basis and a common quantization step is used among a plurality of kernel indices or a plurality of edge indices, or among a plurality of kernel indices and edge indices;
or
quantization steps are set on an edge-by-edge basis and a common quantization step is used among a plurality of node indices or the plurality of edge indices, or among a plurality of node indices and edge indices.

3. The data processing device (100, 200) according to claim 1 or 2, wherein the parameter data of the neural network is weight information assigned to edges that connect nodes in the neural network.

4. The data processing device (100) according to claim 1, wherein

the compression controlling unit (102) is configured to change the quantization steps on a layer-by-layer basis of the neural network, and
the encoding unit (103) is configured to encode the quantization information that defines the layer-by-layer quantization steps for the neural network.

5. A data processing method comprising:

processing, using a data processing unit (101), input data using a neural network;
determining, using a compression controlling unit (102), quantization steps and generating quantization information that defines the quantization steps, the quantization steps being used when parameter data of the neural network is quantized; and
encoding, using an encoding unit (201), network configuration information and the quantization information to generate compressed data, the network configuration information including the parameter data quantized using the quantization steps determined by the compression controlling unit (102);

**characterized by**

changing, using the compression controlling unit (102), the quantization steps on an edge-by-edge, or kernel-by-kernel basis of the neural network, and
encoding, using the encoding unit (201), the quantization information that defines the edge-by-edge, or kernel-by-kernel quantization steps,
wherein either
quantization steps are set on a kernel-by-kernel basis and a common quantization step is used among a plurality of kernel indices or a plurality of edge indices, or among a plurality of kernel indices and edge indices;

or

quantization steps are set on an edge-by-edge basis and a common quantization step is used among a plurality of node indices or the plurality of edge indices, or among a plurality of node indices and edge indices.

6. A data processing method comprising:

a step of, by a decoding unit (201), decoding (ST1a) compressed data obtained by encoding quantization information and network configuration information, the quantization information defining quantization steps used when parameter data of a neural network is quantized, the network configuration information including the parameter data quantized using the quantization steps in the quantization information; and a step of, by a data processing unit (202), inversely quantizing (ST2a) the parameter data using the quantization information and the network configuration information which are decoded from the compressed data by the decoding unit (201), constructing (ST3a) the neural network using the network configuration information including the inversely quantized parameter data, and processing (ST4a) input data using the neural network;

**characterized in that**

in the compressed data,
the quantization steps are changed on an edge-by-edge, or kernel-by-kernel basis of the neural network, and
the quantization information that defines the edge-by-edge, or kernel-by-kernel quantization steps is encoded,
wherein either
quantization steps are set on a kernel-by-kernel basis and a common quantization step is used among a plurality of kernel indices or a plurality of edge indices, or among a plurality of kernel indices and edge indices;

or

quantization steps are set on an edge-by-edge basis and a common quantization step is used among a plurality of node indices or the plurality of edge indices, or among a plurality of node indices and edge indices.

7. Compressed data generated by the data processing device according to claim 1 or the data processing method according to claim 5, wherein

the compressed data is configured to cause a data processing device (200) to inversely quantize the parameter data using the quantization information and the network configuration information which are decoded from the compressed data by the data processing device (200), and to construct the neural network using the network configuration information including the inversely quantized parameter data.

**Patentansprüche**

1. Datenverarbeitungsvorrichtung (100), umfassend:

eine Datenverarbeitungseinheit (101), die eingerichtet ist, Eingabedaten unter Verwendung eines neuronalen Netzwerks zu verarbeiten;
eine Kompressionssteuereinheit (102), die eingerichtet ist, Quantisierungsschritte zu bestimmen und Quantisierungsinformationen zu erzeugen, die die Quantisierungsschritte definieren, wobei die Quantisierungsschritte verwendet werden, wenn Parameterdaten des neuronalen Netzwerks quantisiert werden; und
eine Codiereinheit (103), die eingerichtet ist, die Netzwerkkonfigurationsinformationen und die Quantisierungsinformationen zu codieren, um komprimierte Daten zu erzeugen, wobei die Netzwerkkonfigurationsinformationen die Parameterdaten enthalten, die unter Verwendung der von der Kompressionssteuereinheit (102) bestimmten Quantisierungsschritte quantisiert wurden;
**dadurch gekennzeichnet, dass**
die Kompressionssteuereinheit (102) eingerichtet ist, die Quantisierungsschritte auf einer kantenweisen oder kernelweisen Basis des neuronalen Netzwerks zu ändern, und
die Codierungseinheit (201) eingerichtet ist, die Quantisierungsinformationen zu codieren, die die kantenweisen oder kernelweisen Quantisierungsschritte definieren,
wobei entweder
die Quantisierungsschritte für jeden Kernel einzeln festgelegt werden, und einen gemeinsamen Quantisierungsschritt für eine Vielzahl von Kernel-Indizen oder eine Vielzahl von Kantenindizen oder für eine Vielzahl von Kernel-Indizen und Kantenindizen verwendet;
oder
die Quantisierungsschritte für jede Kante einzeln festgelegt werden, und einen gemeinsamen Quantisierungsschritt für eine Vielzahl von Knotenindizen oder die Vielzahl von Kantenindizen oder für eine Vielzahl von Knotenindizen und Kantenindizen verwendet wird.

2. Datenverarbeitungsvorrichtung (200), umfassend:

eine Datenverarbeitungseinheit (202), eingerichtet zum Verarbeiten von Eingabedaten unter Verwendung eines neuronalen Netzwerks; und eine Decodiereinheit (201), eingerichtet zum Decodieren komprimierter Daten, die durch Codieren von Quantisierungsinformationen und Netzwerkkonfigurationsinformationen erhalten wurden, wobei die Quantisierungsinformationen Quantisierungsschritte definieren, die verwendet werden, wenn Parameterdaten des neuronalen Netzwerks quantisiert werden, und die Netzwerkkonfigurationsinformationen die Parameterdaten enthalten, die unter Verwendung der Quantisierungsschritte in den Quantisierungsinformationen quantisiert wurden, wobei

die Datenverarbeitungseinheit (202) eingerichtet ist, die Parameterdaten unter Verwendung der Quantisierungsinformationen und der Netzwerkkonfigurationsinformationen, die von der Decodiereinheit (201) aus den komprimierten Daten decodiert werden, invers zu quantisieren und das neuronale Netzwerk unter Verwendung der Netzwerkkonfigurationsinformationen einschließlich der invers quantisierten Parameterdaten zu konstruieren;

**dadurch gekennzeichnet, dass**
in den komprimierten Daten,
die Quantisierungsschritte auf einer kantenweisen oder kernelweisen Basis des neuronalen Netzwerks geändert werden, und
die Quantisierungsinformationen, die die kantenweisen oder kernelweisen Quantisierungsschritte definieren, werden codiert,
wobei entweder
die Quantisierungsschritte für jeden Kernel einzeln festgelegt werden, und einen gemeinsamen Quantisierungsschritt für eine Vielzahl von Kernel-Indizes oder eine Vielzahl von Kantenindizen oder für eine Vielzahl von Kernel-Indizen und Kantenindizen verwendet;
oder
die Quantisierungsschritte für jede Kante einzeln festgelegt werden, und einen gemeinsamen Quantisierungsschritt für eine Vielzahl von Knotenindizen oder die Vielzahl von Kantenindizen oder für eine Vielzahl von Knotenindizen und Kantenindizen verwendet wird.

3. Datenverarbeitungsvorrichtung (100, 200) nach Anspruch 1 oder 2, wobei die Parameterdaten des neuronalen Netzwerks Gewichtungsinformationen sind, die Kanten zugeordnet sind, die Knoten im neuronalen Netzwerk verbinden.

4. Datenverarbeitungsvorrichtung (100) nach Anspruch 1, wobei

die Kompressionssteuereinheit (102) eingerichtet ist, die Quantisierungsschritte auf einer schichtweisen Basis des neuronalen Netzwerks zu ändern, und
die Codiereinheit (103) eingerichtet ist, die Quantisierungsinformationen zu codieren, die die schichtweisen Quantisierungsschritte für das neuronale Netzwerk definieren.

5. Datenverarbeitungsverfahren, umfassend:

eine Verarbeitung der Eingabedaten unter Verwendung einer Datenverarbeitungseinheit (101) unter Verwendung eines neuronalen Netzwerks;
Bestimmen von Quantisierungsschritten unter Verwendung einer Kompressionssteuereinheit (102) und Erzeugen von Quantisierungsinformationen, die die Quantisierungsschritte definieren, wobei die Quantisierungsschritte verwendet werden, wenn Parameterdaten des neuronalen Netzwerks quantisiert werden; und
Codieren von Netzwerkkonfigurationsinformationen unter Verwendung einer Codiereinheit (201) und Erzeugen von komprimierten Daten unter Verwendung der Quantisierungsinformationen, wobei die Netzwerkkonfigurationsinformationen die Parameterdaten enthalten, die unter Verwendung der von der Kompressionssteuereinheit (102) bestimmten Quantisierungsschritte quantisiert wurden;

**gekennzeichnet durch**
Ändern auf einer kantenweisen oder kernelweisen Basis der Quantisierungsschritte des neuronalen Netzwerks unter Verwendung der Kompressionssteuereinheit (102) und
Codieren der Quantisierungsinformationen, die die kantenweisen oder kernelweisen Quantisierungsschritte definieren, unter Verwendung der Codiereinheit (201),
wobei entweder
die Quantisierungsschritte für jeden Kernel einzeln festgelegt werden, und einen gemeinsamen Quantisierungsschritt für eine Vielzahl von Kernel-Indizes oder eine Vielzahl von Kantenindizen oder für eine Vielzahl von Kernel-Indizen und Kantenindizen verwendet;
oder
die Quantisierungsschritte für jede Kante einzeln festgelegt werden, und einen gemeinsamen Quantisierungsschritt für eine Vielzahl von Knotenindizen oder die Vielzahl von Kantenindizen oder für eine Vielzahl von Knotenindizen und Kantenindizen verwendet wird.

6. Datenverarbeitungsverfahren, umfassend:

einen Schritt, bei dem eine Decodiereinheit (201) komprimierte Daten decodiert (ST1a), die durch Codieren von Quantisierungsinformationen und Netzwerkkonfigurationsinformationen erhalten wurden, wobei die Quantisierungsinformationen Quantisierungsschritte definieren, die verwendet werden, wenn Parameterdaten eines neuronalen Netzwerks quantisiert werden, und die Netzwerkkonfigurationsinformationen die Parameterdaten enthalten, die unter Verwendung der Quantisierungsschritte in den Quantisierungsinformationen quantisiert wurden; und

einen Schritt, bei dem eine Datenverarbeitungseinheit (202) die Parameterdaten unter Verwendung der Quantisierungsinformationen und der Netzwerkkonfigurationsinformationen, die von der Decodiereinheit (201) aus den komprimierten Daten decodiert werden, invers quantisiert (ST2a), das neuronale Netzwerk unter Verwendung der Netzwerkkonfigurationsinformationen einschließlich der invers quantisierten Parameterdaten konstruiert (ST3a) und Eingabedaten unter Verwendung des neuronalen Netzwerks verarbeitet (ST4a);

**dadurch gekennzeichnet, dass**
in den komprimierten Daten,
die Quantisierungsschritte auf einer kantenweisen oder kernelweisen Basis des neuronalen Netzwerks geändert werden, und
die Quantisierungsinformationen, die die kantenweisen oder kernelweisen Quantisierungsschritte definieren, werden codiert,
wobei entweder
die Quantisierungsschritte für jeden Kernel einzeln festgelegt werden, und einen gemeinsamen Quantisierungsschritt für eine Vielzahl von Kernel-Indizes oder eine Vielzahl von Kantenindizen oder für eine Vielzahl von Kernel-Indizes und Kantenindizen verwendet;
oder
die Quantisierungsschritte für jede Kante einzeln festgelegt werden, und einen gemeinsamen Quantisierungsschritt für eine Vielzahl von Knotenindizen oder die Vielzahl von Kantenindizen oder für eine Vielzahl von Knotenindizen und Kantenindizen verwendet wird.

7. Komprimierte Daten, die von der Datenverarbeitungsvorrichtung gemäß Anspruch 1 oder dem Datenverarbeitungsverfahren gemäß Anspruch 5 erzeugt werden, wobei
die komprimierten Daten eingerichtet sind, eine Datenverarbeitungseinheit (200) zu veranlassen, die Parameterdaten unter Verwendung der Quantisierungsinformationen und der Netzwerkkonfigurationsinformationen, die von der Datenverarbeitungseinheit (200) aus den komprimierten Daten decodiert werden, invers zu quantisieren, und das neuronale Netzwerk unter Verwendung der Netzwerkkonfigurationsinformationen einschließlich der invers quantisierten Parameterdaten zu konstruieren.

**Revendications**

1. Dispositif de traitement de données (100) comprenant :

une unité de traitement de données (101) configurée pour traiter des données d'entrée en utilisant un réseau neuronal ;
une unité de commande de compression (102) configurée pour déterminer des étapes de quantification et générer des informations de quantification qui définissent les étapes de quantification, les étapes de quantification étant utilisées lorsque des données de paramètres du réseau neuronal sont quantifiées ; et
une unité de codage (103) configurée pour coder des informations de configuration de réseau et les informations de quantification afin de générer des données compressées, les informations de configuration de réseau comprenant les données de paramètres quantifiées à l'aide des étapes de quantification déterminées par l'unité de commande de compression (102) ;
**caractérisé en ce que**
l'unité de commande de compression (102) est configurée pour changer les étapes de quantification sur une base bord par bord, ou noyau par noyau du réseau neuronal, et
l'unité de codage (201) est configurée pour coder les informations de quantification qui définissent les étapes de quantification bord par bord, ou noyau par noyau,
dans lequel
des étapes de quantification sont définies sur une base noyau par noyau et une étape de quantification commune est utilisée parmi une pluralité d'indices de noyau ou une pluralité d'indices de bord, ou parmi une pluralité d'indices de noyau et d'indices de bord ;
ou
des étapes de quantification sont définies sur une base bord par bord et une étape de quantification commune est utilisée parmi une pluralité d'indices de nœud ou la pluralité d'indices de bord, ou parmi une pluralité d'indices de nœud et d'indices de bord.

2. Dispositif de traitement de données (200) comprenant :

une unité de traitement de données (202) configurée pour traiter des données d'entrée en utilisant un réseau neuronal ; et

une unité de décodage (201) configurée pour décoder des données compressées obtenues en codant des informations de quantification et des informations de configuration de réseau, les informations de quantification définissant des étapes de quantification utilisées lorsque des données de paramètres du réseau neuronal sont quantifiées, et les informations de configuration de réseau comprenant les données de paramètres quantifiées à l'aide des étapes de quantification dans les informations de quantification, dans lequel

l'unité de traitement de données (202) est configurée pour quantifier de manière inverse les données de paramètres à l'aide des informations de quantification et des informations de configuration de réseau qui sont décodées à partir des données compressées par l'unité de décodage (201), et construire le réseau neuronal à l'aide des informations de configuration de réseau comprenant les données de paramètres quantifiées de manière inverse ;

**caractérisé en ce que**

dans les données compressées,

les données de quantification sont changées sur une base bord par bord, ou noyau par noyau du réseau neuronal, et

les informations de quantification qui définissent les étapes de quantification bord par bord, ou noyau par noyau, sont codées,

dans lequel

des étapes de quantification sont définies sur une base noyau par noyau et une étape de quantification commune est utilisée parmi une pluralité d'indices de noyau ou une pluralité d'indices de bord, ou parmi une pluralité d'indices de noyau et d'indices de bord ;

ou

des étapes de quantification sont définies sur une base bord par bord et une étape de quantification commune est utilisée parmi une pluralité d'indices de nœud ou la pluralité d'indices de bord, ou parmi une pluralité d'indices de nœud et d'indices de bord.

3. Dispositif de traitement de données (100, 200) selon la revendication 1 ou 2, dans lequel les données de paramètre du réseau neuronal sont des informations de pondération attribuées à des bords qui connectent des nœuds dans le réseau neuronal.

4. Dispositif de traitement de données (100) selon la revendication 1, dans lequel

l'unité de commande de compression (102) est configurée pour changer les étapes de quantification sur une base couche par couche du réseau neuronal, et

l'unité de codage (103) est configurée pour coder les informations de quantification qui définissent les étapes de quantification couche par couche pour le réseau neuronal.

5. Procédé de traitement de données comprenant les étapes consistant à :

traiter, à l'aide d'une unité de traitement de données (101), des données d'entrée en utilisant un réseau neuronal ;

déterminer, en utilisant une unité de commande de compression (102), des étapes de quantification et générer des informations de quantification qui définissent les étapes de quantification, les étapes de quantification étant utilisées lorsque des données de paramètres du réseau neuronal sont quantifiées ; et

coder, en utilisant une unité de codage (201), des informations de configuration de réseau et les informations de quantification afin de générer des données compressées, les informations de configuration de réseau comprenant les données de paramètres quantifiées à l'aide des étapes de quantification déterminées par l'unité de commande de compression (102) ;

**caractérisé par** les étapes consistant à

changer, en utilisant l'unité de commande de compression (102), les étapes de quantification sur une base bord par bord, ou noyau par noyau du réseau neuronal, et

coder, en utilisant l'unité de codage (201), les informations de quantification qui définissent les étapes de quantification bord par bord, ou noyau par noyau,

dans lequel

des étapes de quantification sont définies sur une base noyau par noyau et une étape de quantification commune est utilisée parmi une pluralité d'indices de noyau ou une pluralité d'indices de bord, ou parmi une pluralité d'indices de noyau et d'indices de bord ;

ou

des étapes de quantification sont définies sur une base bord par bord et une étape de quantification commune est utilisée parmi une pluralité d'indices de nœud ou la pluralité d'indices de bord, ou parmi une pluralité d'indices de nœud et d'indices de bord.

6. Procédé de traitement de données comprenant les étapes consistant à :

une étape consistant à, par l'intermédiaire d'une unité de décodage (201), décoder (ST1a) des données compressées obtenues en codant des informations de quantification et des informations de configuration de réseau, les informations de quantification définissant des étapes de quantification utilisées lorsque des données de paramètres d'un réseau neuronal sont quantifiées, les informations de configuration de réseau comprenant les données de paramètres quantifiées à l'aide des étapes de quantification dans les informations de quantification ; et

une étape consistant à, par l'intermédiaire d'une unité de traitement de données (202), quantifier de manière inverse (ST2a) les données de paramètres à l'aide des informations de quantification et des informations de configuration de réseau qui sont décodées à partir des données compressées par l'intermédiaire de l'unité de décodage (201), construire (ST3a) le réseau neuronal à l'aide des informations de configuration de réseau comprenant les données de paramètres quantifiées de manière inverse, et traiter (ST4a) les données d'entrée à l'aide du réseau neuronal ;

**caractérisé en ce que**

dans les données compressées,

les données de quantification sont changées sur une base bord par bord, ou noyau par noyau du réseau neuronal, et

les informations de quantification qui définissent les étapes de quantification bord par bord, ou noyau par noyau, sont codées,

dans lequel

des étapes de quantification sont définies sur une base noyau par noyau et une étape de quantification commune est utilisée parmi une pluralité d'indices de noyau ou une pluralité d'indices de bord, ou parmi une pluralité d'indices de noyau et d'indices de bord ;

ou

des étapes de quantification sont définies sur une base bord par bord et une étape de quantification commune est utilisée parmi une pluralité d'indices de nœud ou la pluralité d'indices de bord, ou parmi une pluralité d'indices de nœud et d'indices de bord.

7. Données compressées générées par le dispositif de traitement de données selon la revendication 1 ou le procédé de traitement de données selon la revendication 5, dans lesquelles

les données compressées sont configurées pour amener un dispositif traitement de données (200) à quantifier de manière inverse les données de paramètres en utilisant les informations de quantification et des informations de configuration de réseau qui sont décodées à partir des données compressées par l'intermédiaire du dispositif traitement de données (200), et construire le réseau neuronal en utilisant les informations de configuration de réseau comprenant les données de paramètres quantifiées de manière inverse.

FIG. 1

FIG. 2

# FIG. 3A

# FIG. 3B

# FIG. 4

# FIG. 5

Start

| Decode Compressed Data | ~ST1a |

| Calculate Inversely Quantized Weight Information From Network Configuration Information And Quantization Information | ~ST2a |

| Construct Neural Network From Network Configuration Information Including Inversely Quantized Weight Information | ~ST3a |

| Process Input Data Using Neural Network | ~ST4a |

End

FIG. 6

FIG. 7

Kernel Size: K (= 5)

Number Of Steps: S (= 2)

10-1

10-2

10-3

10-4

10-5

10-6

10-7

10-8

10-9

11-1

11-2

11-3

12-1

12-2

12-3

12-4

12-5

12-6

12-7

12-8

12-9

12-10

12-11

12-12

12-13

12-14

12-15

FIG. 8

# FIG. 9

| | | Node Index | | | | |
|---|---|---|---|---|---|---|
| | | 1 | 2 | 3 | $\cdots$ | $N_1$ |
| Edge Index | 1 | $w_{11}$ | $w_{21}$ | $w_{31}$ | $\cdots$ | $w_{N_11}$ |
| | 2 | $w_{12}$ | $w_{22}$ | $w_{32}$ | $\cdots$ | $w_{N_12}$ |
| | 3 | $w_{13}$ | $w_{23}$ | $w_{33}$ | $\cdots$ | $w_{N_13}$ |
| | $\vdots$ | $\vdots$ | $\vdots$ | $\vdots$ | $\cdots$ | $\vdots$ |
| | $N_{1-1}$ | $w_{1N_{1-1}}$ | $w_{2N_{1-1}}$ | $w_{3N_{1-1}}$ | $\cdots$ | $w_{N_1N_{1-1}}$ |

# FIG. 10

| | | Node Index | | | | |
|---|---|---|---|---|---|---|
| | | 1 | 2 | 3 | $\cdots$ | $N_1$ |
| Edge Index | 1 | $q_{11}$ | $q_{21}$ | $q_{31}$ | $\cdots$ | $q_{N_11}$ |
| | 2 | $q_{12}$ | $q_{22}$ | $q_{32}$ | $\cdots$ | $q_{N_12}$ |
| | 3 | $q_{13}$ | $q_{23}$ | $q_{33}$ | $\cdots$ | $q_{N_13}$ |
| | $\vdots$ | $\vdots$ | $\vdots$ | $\vdots$ | $\cdots$ | $\vdots$ |
| | $N_{1-1}$ | $q_{1N_{1-1}}$ | $q_{2N_{1-1}}$ | $q_{3N_{1-1}}$ | $\cdots$ | $q_{N_1N_{1-1}}$ |

# FIG. 11

| | | Kernel Index | | | | |
|---|---|---|---|---|---|---|
| | | 1 | 2 | 3 | $\cdots$ | $M_l$ |
| | 1 | $w_{11}$ | $w_{21}$ | $w_{31}$ | $\cdots$ | $w_{M_l1}$ |
| | 2 | $w_{12}$ | $w_{22}$ | $w_{32}$ | $\cdots$ | $w_{M_l2}$ |
| Edge Index | 3 | $w_{13}$ | $w_{23}$ | $w_{33}$ | $\cdots$ | $w_{M_l3}$ |
| | $\vdots$ | $\vdots$ | $\vdots$ | $\vdots$ | $\cdots$ | $\vdots$ |
| | $K_l$ | $w_{1K_l}$ | $w_{2K_l}$ | $w_{3K_l}$ | $\cdots$ | $w_{M_lK_l}$ |

# FIG. 12

| | | Kernel Index | | | | |
|---|---|---|---|---|---|---|
| | | 1 | 2 | 3 | $\cdots$ | $M_l$ |
| | 1 | $q_{11}$ | $q_{21}$ | $q_{31}$ | $\cdots$ | $q_{M_l1}$ |
| | 2 | $q_{12}$ | $q_{22}$ | $q_{32}$ | $\cdots$ | $q_{M_l2}$ |
| Edge Index | 3 | $q_{13}$ | $q_{23}$ | $q_{33}$ | $\cdots$ | $q_{M_l3}$ |
| | $\vdots$ | $\vdots$ | $\vdots$ | $\vdots$ | $\cdots$ | $\vdots$ |
| | $K_l$ | $q_{1K_l}$ | $q_{2K_l}$ | $q_{3K_l}$ | $\cdots$ | $q_{M_lK_l}$ |

# FIG. 13

```
quant_coding() {
  quant_enable_flag
  if (quant_enable_flag) {
    layer_adaptive_quant_flag
    if (layer_adaptive_quant_flag) {
      matrix_adaptive_quant_flag
      if (matrix_adaptive_quant_flag) {
        for (i =1; i < L; i++)
          matrix_quant_coding(i)
      } else {
        layer_quant_coding()
      }
    } else {
      fixed_quant_step
    }
  }
}
```

# FIG. 14

```
matrix_quant_coding(layer_id) {
  for (j =0; j < E; j++)
    base_quant_step[j]
  for (i =1; i < C; i++) {
    prev_quant_copy_flag[i-1]
    if (!prev_quant_copy_flag[i-1]) {
      for (j =0; j < E; j++)
        diff_quant_value[i-1][j]
    }
  }
}
```

# FIG. 15

```
layer_quant_coding() {
  base_layer_quant_step
  for (i =2; i < L; i++) {
    layer_quant_copy_flag[i-2]
    if (!layer_quant_copy_flag[i-2])
      layer_quant_step[i-2]
  }
}
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **VINCENT VANHOUCKE** ; **ANDREW SENIOR** ; **MARK Z. MAO**. Improving the speed of neural networks on CPUs. *Proc. Deep Learning and Unsupervised Feature Learning NIPS Workshop*, 2011

- **SAJID ANWAR et al.** Fixed point optimization of deep convolutional neural networks for object recognition. *2015 IEEE INT. CONF. ON ACOUSTICS, SPEECH AND SIGNAL PROCESSING (ICASSP)*
- **CHENGDU, CHINA**. Improved retrieval and matching with CNN feature for CDVA. *ISO/IEC JTC1/SC29/WG11/m39219*, October 2016